# EUROPEAN PATENT APPLICATION

(11) **EP 4 753 378 A1**
(43) Date of publication of application: **03.06.2026**
(21) Application number: 24216649.4
(22) Date of filing: 29.11.2024
(51) Int. Cl.: H05K 1/02, H05K 1/11, H05K 3/00, H05K 3/10, H05K 3/18, H05K 3/22, H05K 3/40, H05K 3/42, H05K 3/46, H05K 1/03

(54) **MODULAR SEMI-FINISHED WIRING PRODUCT, WIRING MODULE AND WIRING COMPONENT**

(71) Applicant: Fraunhofer-Gesellschaft zur Förderung der angewandten Forschung e.V., 80686 München (DE)
(72) Inventor: Wöhrmann, Markus, 13355 Berlin (DE)
(74) Representative: Pfenning, Meinig & Partner mbB

(57) **Abstract**

The disclosure describes a semi-finished wiring product (100) comprising a first conductor track layer (120) and a second conductor track layer (140). The first conductor track layer (120) has a plurality of first conductor track arrangements (122) extending parallel to one another. The second conductor track layer (140) is arranged on a surface of the first conductor track layer (120) and has a plurality of second conductor track arrangements (142) extending parallel to one another. The arrangement is such that at least one of the second conductor track arrangements (142) intersects one of the first conductor track arrangements (122). Furthermore, an outer surface (146) of the second conductive track layer (120) has a contact surface (148) in at least one intersection region, at which one of the first conductive track arrangements (122) intersects with one of the second conductive track arrangements (142), which is electrically conductively connected to the first and second conductive track arrangements (122, 142) located in the intersection region. The first conductive track arrangements (122) and the second conductive track arrangements (142) further comprise a first conductive track (122A, 142A) electrically connected to each contact surface (148) arranged along its course. Furthermore, the first conductor track arrangements (122) and/or the second conductor track arrangements (148) each comprise a second conductor track (122B, 142B) which is electrically connected to at most every second contact surface (148) arranged along its course.

## Description

The invention relates to a semi-finished wiring product, wiring module and wiring component and a method of manufacturing the same.

Multilayer carrier elements for electronic components, such as printed circuit boards, are typically manufactured sequentially. Each layer is first individually structured by applying conductive tracks to a carrier that connect specific nodes according to a specified two-dimensional electrical network. The next individually structured layer is then applied to this individually structured layer in order to form a predetermined three-dimensional electrical network. However, this type of production, in which each work step is carried out individually, is very time-consuming and cost-intensive. Both the time required and the costs have a negative impact on small series production of specialized computer hardware as well as on prototype construction in the development phase of computer hardware.

DE 10 2020 208 591 A1 discloses a semi-finished wiring product comprising a grid, at least one first contact block, at least one second contact block, at least one first electrical contact element and/or at least one second electrical contact element. Furthermore, at least one hole is formed in the at least one second contact block, which enables selective structuring of the grid in accordance with a predetermined two-dimensional electrical network.

The semi-finished wiring product disclosed in DE 10 2020 208 591 A1 can be quickly adapted to the requirements of a particular application by selectively structuring the grid.

It is now the aim of the present invention to provide products and methods with which further improved manufacturing of multilayer carrier elements for electronic parts and components is possible.

According to the invention, the problem is solved with the features mentioned in claims 1, 7, 9, 14, 15, 16 and 17. Advantageous variants can be derived from the features mentioned in the subclaims.

The invention relates to a semi-finished wiring product comprising a first conductor track layer and a second conductor track layer.

The first conductor track layer has a plurality of first conductor track arrangements running parallel to each other. The second conductor track layer is arranged on a surface of the first conductor track layer. Furthermore, the second conductor track layer has a plurality of second conductor track arrangements running parallel to one another, at least one of the second conductor track arrangements intersecting one of the first conductor track arrangements and an outer surface of the second conductor track layer having, in at least one intersection region at which one of the first conductor track arrangements intersect one of the second conductor track arrangements, a contact surface which is electrically conductively connected to the first and second conductor track arrangements located in the intersection region.

Furthermore, the first conductor track arrangements and the second conductor track arrangements each comprise a first conductor track which is electrically connected to each contact surface arranged along its course. In addition, the first conductor track arrangements and/or the second conductor track arrangements each comprise a second conductor track which is electrically connected to at most every second contact surface arranged along its course.

The semi-finished wiring product described above provides a wiring network that can be quickly adapted to the respective application by simple means. The contact surfaces represent input and output interfaces of the wiring network. The semi-finished wiring product can be a prefabricated partial element of a multi-layer carrier element. The semi-finished wiring product has a universal structure and can be stored temporarily until it is individually structured. In particular, it can be produced or prefabricated quickly and easily. As will be explained in more detail later, individualization can be achieved by subsequently structuring the semiconductor tracks according to a predetermined electrical network.

Furthermore, the routing of the conductor tracks enables not only the wiring of directly adjacent conductors, but also the wiring of conductors that are not directly adjacent without involving intermediate conductor tracks. This allows not only a two-dimensional connection network to be realized, but also a three-dimensional electrical network.

The semi-finished wiring product can also have a substrate or a release layer. In particular, the substrate can be arranged on a side of the first conductor track layer facing away from the second conductor track layer. Preferably, the release layer, which can be formed with an electrically insulating material, is arranged between the substrate and the first conductor track layer. The release layer can also have several layers, each of which can be formed with a different material or a different material composition. In the context of the present disclosure, the release layer is also referred to as a separation layer.

A conductor track can have a width of between 1 µm and 10 µm and a thickness of between 1 µm and 10 µm. The distance between two adjacent conductor tracks is preferably between 1 µm and 10 µm.

The first conductor track arrangements and/or the second conductor track arrangements can be spaced apart in such a way that a periodic arrangement of the contact surfaces is produced or that a plurality of spaced-apart fields are produced in which the contact surfaces are arranged periodically.

Furthermore, one or more conductor tracks, preferably all conductor tracks, of the first and/or second conductor track arrangement can have an interruption in electrical conductivity along their course between two adjacent contact surfaces. The semi-finished wiring product can be adapted to a given application by bridging the interruptions in the semi-finished wiring product.

If one or more of the conductor tracks has an interruption, the outer surface of the second conductor track layer can also have a recess above one or more of the interruptions, which extends vertically to the interruption. Bridging elements can be inserted through these recesses to bridge the respective interruption during subsequent customization of the semi-finished wiring product.

Alternatively or additionally, one or more of the conductor tracks can also have locally and universally formed tapers. The respective conductor track can then be structured using probe needles, whereby current pulses are transmitted to the conductor track via the contact surfaces using the probe needles in the area of a selected taper in such a way that the conductor track is interrupted in the area of the selected taper in accordance with the specified three-dimensional electrical network.

Furthermore, the first conductor track arrangements and/or the second conductor track arrangements can comprise a third conductor track which runs parallel to the first and second conductor tracks and is electrically connected along its course to at most every third contact surface.

Furthermore, the first conductor track layer can comprise a passivation layer which electrically insulates the first conductor track arrangements and the second conductor track arrangements from one another, an electrically conductive contact element being arranged in each of the intersection regions within the passivation layer, which electrically conductively connects the first conductor track arrangement located in the intersection region to the second conductor track arrangement. In addition or alternatively, the second conductor track layer may comprise a passivation layer which covers the second conductor track arrangements and forms the outer surface, the passivation layer comprising recesses in the intersection areas in which the contact surfaces are arranged.

Preferably, the passivation layer is formed with an electrically insulating material, such as a polymer. For example, the passivation layer can be designed as a coating layer applied using thin-film technology.

Preferably, an electrically conductive material, an electrically conductive layer or an electrically conductive compound can have an electrical conductivity of at least 10⁵ S/m, preferably of at least 10⁶ S/m, particularly preferably of at least 10⁷ S/m. An electrically insulating material or an electrically insulating layer can have an electrical conductivity of less than 10⁻⁵ S/m, preferably less than 10⁻⁶ S/m, particularly preferably less than 10⁻⁷ S/m.

The contact surfaces can, for example, be formed with nickel, gold and/or a solderable metallization, for example with a gold-tin metallization or with a tin-silver-copper metallization.

The invention also provides a method of manufacturing a semi-finished wiring product in which a first conductor track layer comprising a plurality of first conductor track arrangements running parallel to one another is applied to a surface of a substrate. Furthermore, in the method, a second conductor track layer is applied to a surface of the first conductor track layer facing away from the substrate, wherein the second conductor track layer has a plurality of second conductor track arrangements running parallel to one another, the second conductor track arrangements being applied in such a way that at least one of the second conductor track arrangements intersects at least one of the first conductor track arrangements. In addition, a contact surface is applied to an outer surface of the second conductor track layer in at least one intersection region, at which one of the first conductor track arrangements intersects with one of the second conductor track arrangements, which is electrically connected to the first and second conductor track arrangement located in the intersection region. Furthermore, the first conductor track arrangements and the second conductor track arrangements each comprise a first conductor track, which is electrically connected to each contact surface arranged along its course as part of the method. In addition, the first conductor track arrangements and/or the second conductor track arrangements each comprise a second conductor track, which is electrically connected to at most every second contact surface arranged along its course.

As part of this process, the first conductor track layer and/or the second conductor track layer can be applied using thin-film technology. Furthermore, a release layer can be applied to the surface of the substrate before the first conductor track layer is applied.

When applying the first conductor track layer, the first conductor track arrangements can be applied first and then the first conductor track arrangements can be covered with a passivation layer. Furthermore, in areas that form a intersection region after application of the second conductor track layer, a recess can be made in each intersection region that extends from a surface of the passivation layer facing away from the substrate to the respective first conductor track arrangement.

Furthermore, when applying the second conductor track layer, the second conductor track arrangements can be applied first and then the second conductor track arrangements can be covered with a passivation layer. A recess can be made in each of the intersection regions, which extends from a surface of the passivation layer facing away from the substrate to the second conductor track arrangement. In addition, the contact surfaces can be placed in the recesses of the passivation layer, preferably by electroplating.

As part of the method, one or more conductor tracks, preferably all conductor tracks, of the first and/or the second conductor track arrangement can also be applied in such a way that a conductivity of the one or more conductor tracks is interrupted along their course between two adjacent contact surfaces. It is advantageous here if a recess is made in the outer surface of the second conductor track layer above one or more of the interruptions, which extends vertically to the interruption. The interruption can be formed by means of a material-removing process. Alternatively or additionally, the interruption can be created by means of a masking applied during an additive process.

As an alternative to the process described above, the semi-finished wiring product can also be manufactured using a pre-machined substrate.

Such a pre-processed substrate comprises a first surface and a second surface opposite the first surface. Furthermore, the pre-processed substrate comprises first channel arrangements in the form of parallel recesses in the first surface and second channel arrangements in the form of parallel recesses in the second surface, wherein at least one of the first channel arrangements intersects one of the second channel arrangements. In addition, in at least one intersection region where one of the first channel arrangements intersects with one of the second channel arrangements, the pre-processed substrate has a through hole, preferably perpendicular to the surfaces, which connects the first channel arrangement to the second channel arrangement. Furthermore, the first channel arrangements and the second channel arrangements each have a first channel which is connected to each through hole arranged along its course. In addition, the first channel arrangements and/or the second channel arrangements each have a second channel, which is connected to at most every second through hole arranged along its course .

Furthermore, one or more channels, preferably all channels, of the first and/or the second channel arrangement of the pre-processed substrate can have an interruption along their respective course between two adjacent intersection regions. These interruptions can be part of the pre-processed substrate itself or can be subsequently introduced into the pre-processed substrate by additive processes after it has been provided. The interruptions can be used to interrupt the electrical conductivity of a metallization subsequently introduced into the channels along the course of the channels.

The pre-processed substrate can be a pre-processed glass substrate. Alternatively, the pre-processed substrate can also be a pre-processed ceramic, silicon or plastic substrate.

The method of manufacturing a semi-finished wiring product by means of the pre-processed substrate, comprising the following steps:
- Providing the pre-processed substrate; and
- Insertion of a metallization into the at least one through hole and the channel arrangements of the pre-processed substrate for producing a first conductor track arrangement in the first channel arrangement, a second conductor track arrangement in the second channel arrangement and, in at least one intersection region, a contact surface which is electrically connected to the first and second conductor track arrangement located in the intersection region.

The first conductor track arrangement can be part of a first conductor track layer. The second conductor track arrangement can be part of a second conductor track layer and the at least one contact surface can be arranged on an outer surface of the second conductor track layer.

The metallization can be applied by applying a seed layer and subsequent electroplating. Copper can also be used as a material here. The seed layer can be applied by sputtering. Electroless deposition of the seed layer on the surface of the pre-processed substrate is also possible. Alternatively, the metallization can be applied by inserting a copper paste into channels and through-holes and then sintering.

Furthermore, the method can also comprise grinding off the metallization on the first surface and/or the second surface.

Furthermore, the method may also comprise applying a solderable metallization in at least one of the intersection areas so that the solderable metallization is electrically connected to the contact surface.

The invention also relates to a wiring module comprising a first conductor track layer having a plurality of first conductor track arrangements running parallel to one another.

Further, the wiring module comprises a second conductive path layer disposed on a surface of the first conductive path layer and having a plurality of second conductive path arrangements extending parallel to each other, wherein at least one of the second conductive path arrangements intersects one of the first conductive path arrangements. Furthermore, an outer surface of the second conductor track layer has a contact surface in at least one intersection region, at which one of the first conductor track arrangements intersects with one of the second conductor track arrangements, which is electrically conductively connected to the first and second conductor track arrangement located in the intersection region.

Furthermore, the first conductor track arrangements and the second conductor track arrangements each comprise a first conductor track which is electrically connected to each contact surface arranged along its course. In addition, the first conductor track arrangements and/or the second conductor track arrangements each comprise a second conductor track which is electrically connected to at most every second contact surface arranged along its course.

Finally, a conductivity of the first conductor track arrangements and/or a conductivity of the second conductor track arrangements is structured so that the contact surfaces are electrically connected to one another in accordance with a predetermined three-dimensional electrical network.

The invention also provides a method for manufacturing a wiring module, which comprises two alternative methods. The first method described below is aimed at the targeted interruption of conductor paths according to a predetermined three-dimensional network. For this purpose, the steps described above or the process for manufacturing a semi-finished wiring product are first carried out and a semi-finished wiring product is manufactured. Subsequently, the electrical conductivity of the first conductor track arrangements and/or the second conductor track arrangements is structured between neighboring contact surfaces by means of a material-removing process in accordance with the specified three-dimensional electrical network.

In the alternative, second method, the steps described above or the method for producing a semi-finished wiring product are first carried out, wherein one or more conductor tracks, preferably all conductor tracks, of the first and/or second conductor track arrangement are applied as part of the method in such a way that a conductivity of the one or more conductor tracks is interrupted along their course between two adjacent contact surfaces. Subsequently, bridging elements are inserted to create an electrical conductivity that bridge any of the one or more interruptions in accordance with the specified three-dimensional electrical network. In the case of recesses in the second conductor track layer, the bridging elements can be inserted through the one or more recesses.

The at least one bridging element can be formed with a printable paste. The conductive tracks and the at least one filling element can also be formed with the same material.

Both processes can also be combined to produce a single wiring module in a single process.

The electrical conductivity can be structured by means of a material-removing process. The material-removing process can be a laser ablation process or an etching process.

Bridging elements can be inserted using an additive process or a semi-additive process. This can be a soldering process or a galvanic deposition process, for example. An additive process can also include printing a paste and/or an inkjet process.

The invention also relates to a wiring component comprising at least a first and a second wiring module.

The first wiring module and the second wiring module are materially connected to each other to form a predetermined extended three-dimensional electrical network, contact surfaces of the first wiring module being connected pairwise to contact surfaces of the second wiring module directly or via a connecting element located between the outer surfaces of the wiring modules. The term "extended" in relation to the three-dimensional network distinguishes the extended three-dimensional electrical network from the previously mentioned three-dimensional electrical network and indicates that the number of electrical connections in the extended three-dimensional electrical network is higher than in the three-dimensional electrical network. However, the term extended can also be omitted if a distinction between the two electrical networks is not necessary.

Optionally, the wiring component can also comprise a third wiring module, wherein the third wiring module and the second wiring module can be connected to each other in a materially bonded manner to form the predetermined extended three-dimensional electrical network, and wherein contact surfaces of the third wiring module can be connected pairwise to contact surfaces of the second wiring module directly or via a connecting element located between the outer surfaces of the wiring modules.

The invention also provides a method of manufacturing a wiring component. The method according to the invention for manufacturing a wiring module is used to first manufacture a first wiring module and a second wiring module.

The first wiring module and the second wiring module are then bonded, preferably by means of Flip-Chip-Bonding and/or hybrid bonding, to form a predetermined extended three-dimensional electrical network, wherein contact surfaces of the second wiring module are pairwise connected to contact surfaces of the first wiring module directly or via a connecting element located between the outer surfaces of the wiring modules. In the context of the present disclosure, the term hybrid bonding is understood to mean a bonding of electrical and insulating layers in one process step.

Examples of embodiments of the present disclosure are shown in the drawings and are explained in more detail below with reference to FIGS. 1 to Fig. 8.

Shown are
- Fig. 1a: is a top view of a semi-finished wiring product that has two layers of conductor tracks;
- Fig. 1b: a cross-section through the semi-finished wiring product shown in Fig. 1a;
- Fig. 2a: A cross-section through an intermediate product of a semi-finished wiring product in the manufacturing process before a contact surface is introduced;
- Fig. 2b: a cross-section through the intermediate production from Fig. 2a after the contact surface has been inserted;
- Fig. 2c: a cross-section through the intermediate product from Fig. 2b after grinding off the contact surface;
- Fig. 3: a top view of a wiring module 300 made from the semi-finished wiring product 100 shown in Figs. 1a and 1b;
- Fig. 4a: a top view of a semi-finished wiring product comprising conductive tracks that have interruptions in their conductivity between adjacent contact surfaces;
- Fig. 4b: a cross-section through the semi-finished wiring product shown in Fig. 4a;
- Fig. 5: a wiring component comprising seven wiring modules;
- Fig. 6a: a first step of a manufacturing process for joining three wiring modules using hybrid bonding;
- Fig. 6b: a second step of a manufacturing process for joining three wiring modules using hybrid bonding;
- Fig. 6c: a third step of a manufacturing process for joining three wiring modules using hybrid bonding;
- Fig. 7: a top view of a semi-finished wiring product comprising contact surfaces arranged periodically in four fields;
- Fig. 8: A top view of a semi-finished wiring product with a first conductor track arrangement comprising three conductor tracks;
- Fig. 9a-d: Illustration of process steps of a method for manufacturing a semi-finished wiring product using a pre-machined glass substrate; and
- Fig. 10a-d: Illustration of process steps of a process for manufacturing a semi-finished wiring product using a pre-machined glass substrate with interruptions.

The embodiments shown in the figures are described in detail below. Reference is made to individual features of the embodiments by means of the reference symbols contained in the figures. The same reference signs are used in the figures to denote the same features.

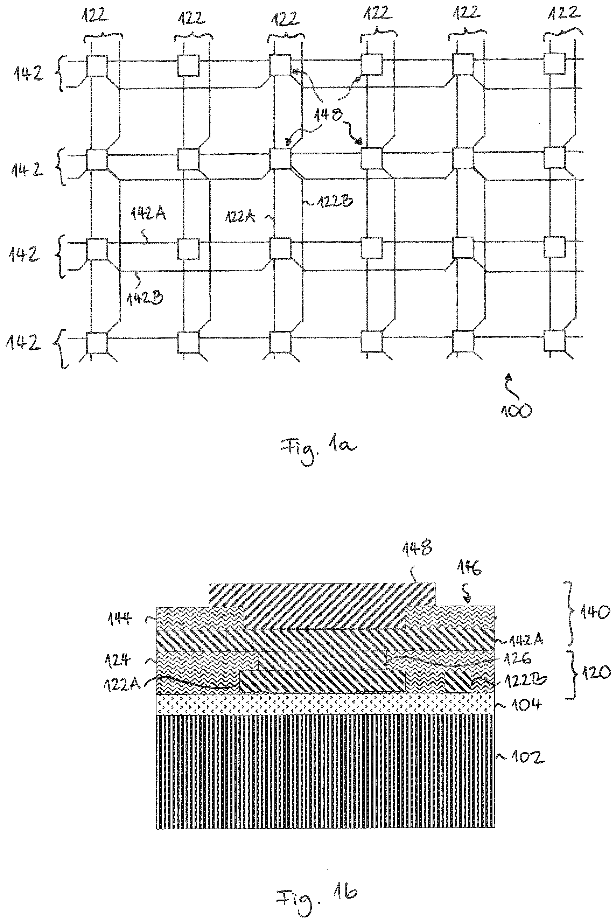

First, an embodiment example 100 of a semi-finished wiring product is described with reference to FIGS. 1a and 1b.

Fig. 1a shows a top view of the semi-finished wiring product 100, which has two conductor track layers 120, 140. The conductor track layers 120, 140 lie on top of each other in the plan view shown in Fig. 1a.

The first conductive track layer 120 comprises a plurality of mutually parallel first conductive track arrangements 122. As will be explained in more detail later with reference to Fig. 1b, the second conductor track layer 140 is arranged above the first conductor track layer 120 and comprises a plurality of second conductor track arrangements 142 running parallel to one another. In the semi-finished wiring product 100 shown in Fig. 1a, the first conductor track arrangements 122 run perpendicular to the second conductor track arrangements 142 in the top view of the semi-finished wiring product 100. However, the angle formed between the first conductive path arrangements 122 and the second conductive path arrangements 142 may be different in other embodiments of the semi-finished wiring device. The only requirement here is that at least one of the first conductor track arrangements 122 intersects with one of the second conductor track arrangements 142.

Each of the first conductive track arrangements 122 and each of the second conductive track arrangements 142 comprise a first conductive track 122A, 142A and a second conductive track 122B, 142B extending parallel thereto.

Due to the perpendicular course of the first conductor track arrangements 122 to the second conductor track arrangements 142, the conductor track arrangements intersect each other. An outer surface of the second conductor track layer has a contact surface 148 in each of the resulting intersection region. The contact surface 148 is electrically conductively connected to the first conductor track arrangement 122 and second conductor track arrangement 142 located in the respective intersection region.

A uniform spacing of adjacent first conductive track arrangements 122 and a uniform spacing of adjacent second conductive track arrangements 142 results in a periodic arrangement of the contact surfaces 148.

The first conductive track 122A of the first conductive track arrangements 122 and the first conductive track 142A of the second conductive track arrangements 142 are thereby electrically connected to each contact surface arranged along their respective course. The second conductive track 122B of the first conductive track arrangements 122 and the second conductive track 142B of the second conductive track arrangements 142 are electrically connected to every second contact surface 148 arranged along their course. For this purpose, the conductive tracks 122B, 142B initially run parallel with respect to the conductive tracks 122A or 142B except in intersection regions in which the conductive tracks 122B, 142B are connected to the respective contact surface 148. In these intersection regions, the course of the conductors 122B, 142B bends towards the respective contact surface 148.

In order to explain the layered structure of the semi-finished wiring product 100 in more detail, reference is made below to Fig. 1b.

Fig. 1b shows a cross-section through the semi-finished wiring product 100 shown in Fig. 1a. The cross-section shown in Fig. 1b corresponds to a cross-section along a first conductor track 142A of one of the second conductor track arrangement 142 in a vicinity of one of the contact surfaces 148.

It can be seen in Fig. 1b that the semi-finished wiring product 100 comprises a substrate 102. A separating layer 104 is arranged on the substrate 102. The first conductive track layer 120 is arranged on a surface of the separating layer 104 facing away from the substrate. Furthermore, the second conductive track layer 140 is arranged above the first conductive track layer 120, i.e. on a surface of the first conductive track layer 120 facing away from the substrate.

Substrate 102 and release layer 104 are layers resulting from the manufacturing process of the semi-finished wiring product 100. In other embodiments of the semi-finished wiring product, these layers may also be removed so that the semi-finished wiring product comprises only the first conductive track layer 120 and the second conductive track layer 140.

The first conductive track arrangements 122 run perpendicular to the image plane of Fig. 1b, which is why the first conductive track 122A and second conductive track 122B encompassed by the first conductive track layer 120 are only shown in cross-section in Fig. 1b. The conductor track 142A of the second conductor track arrangement 142, on the other hand, is shown in Fig. 1b along a longitudinal section.

The second conductive track layer 140 in the embodiment shown in FIGS. 1a and 1b comprises a passivation layer 144 which covers the second conductive track arrangements 142 and at the same time forms the outer surface 146 of the second conductive track layer 140. In the intersection area of the first conductor arrangement 122 and the second conductor arrangement 142, there is a recess in the passivation layer 144, in which the contact surface 148 is arranged. Due to the recess in the passivation layer 144, the contact surface 148 in the intersection region is directly conductively connected to the second conductor track arrangement 142.

In the embodiment shown in FIGS. 1a and 1b, the first conductive track layer 120 also comprises a passivation layer 124 that covers the first conductive track arrangement 122 and thus electrically insulates the first conductive track arrangement 122 from the second conductive track arrangement 142 applied thereover. In order to establish an electrical connection between the contact surface 148 and the first conductive track arrangement 122, an electrically conductive contact element 126 is arranged in the intersection region of a respective contact surface 148 within the passivation layer 124 of the first conductive track layer 120. The contact element 126 electrically connects the first conductor arrangement 122 located in the intersection region to the contact surface 148 via the second conductor arrangement 142. The passivation layer 124 and the passivation layer 144 are each formed as a coating layer with a polymer.

The cross-section shown in Fig. 1b shows a contact surface 148 which is electrically conductively connected in the intersection region only to the first conductor track 122A of the first conductor track arrangement 122 and only to the first conductor track 142A of the second conductor track arrangement 142. This cannot be seen due to the choice of cross-section for the second conductor arrangement shown in Fig. 1b. However, in the first conductive track layer 120, Fig. 1b clearly shows how the first conductive track 122A of the first conductive track arrangement 120 is spaced apart from the second conductive track 122B of the first conductive track arrangement 120 and only the first conductive track 122A is electrically conductively connected to the contact surface 148.

To produce the semi-finished wiring product shown in Figs. 1a and 1b, the first conductor track layer 120 is applied first. For this purpose, a plurality of mutually parallel first conductor track arrangements 122 are applied to the surface of the substrate 102. Subsequently, the first conductor track arrangements 122 are covered with the passivation layer 124, wherein a recess is formed in the passivation layer 124 in regions that form an intersection region after application of the second conductor track layer 140, which recess extends from a surface of the passivation layer 124 facing away from the substrate 102 to the respective first conductor track arrangement 122.

The plurality of mutually parallel second conductor track arrangements 142 of the second conductor track layer 140 is then applied to a surface of the first conductor track layer 120 facing away from the substrate and formed by the passivation layer 124. The second conductive track arrangements 142 are thereby applied relative to the first conductive track arrangements 122 such that at least one of the second conductive track arrangements 142 intersects at least one of the first conductive track arrangements 122. At the same time, the contact element 126 can also be removed in this step.

Subsequently, similar to the production of the first conductor track layer 120, the second conductor track arrangements 142 are covered with a passivation layer 146. Here, a recess is provided in each of the respective intersection regions between first conductor track arrangements 122 and second conductor track arrangements 142, which recess extends from a surface of the passivation layer 146 facing away from the substrate to the second conductor track arrangement 142. The contact surfaces 148 are then inserted into these recesses, preferably by electroplating. As a result of this manufacturing process, the contact surfaces 148 are electrically conductively connected to the first and second conductor track arrangement 122, 142 located in the respective intersection region.

In the embodiment example of the semi-finished wiring shown in Fig. 1a and 1b, the first conductive track arrangements 122 and the second conductive track arrangements 142 are applied in such a way that they each comprise a first conductive track 122A, 142B and a second conductive track 122B, 142 B running parallel thereto. The first conductor tracks 122A, 142A of each conductor track arrangement 122, 142 are each applied in such a way that the first conductor tracks 122A, 142A are electrically connected to each contact surface 148 arranged along their respective course. The second conductive tracks 122B, 142B, on the other hand, are applied such that the second conductive tracks 122B, 142B are electrically connected to every second contact surface arranged along their respective course.

Before applying the first conductive track layer 120 to the substrate 102, it is also possible to first apply the release layer 104 to the substrate 102. The first conductive track layer 120 is then applied to a surface of the release layer 104 facing away from the substrate 102. Furthermore, as part of the manufacturing process, the first conductive track layer 120, the second conductive track layer 140 and also the release layer 104 can be applied using thin-film technology.

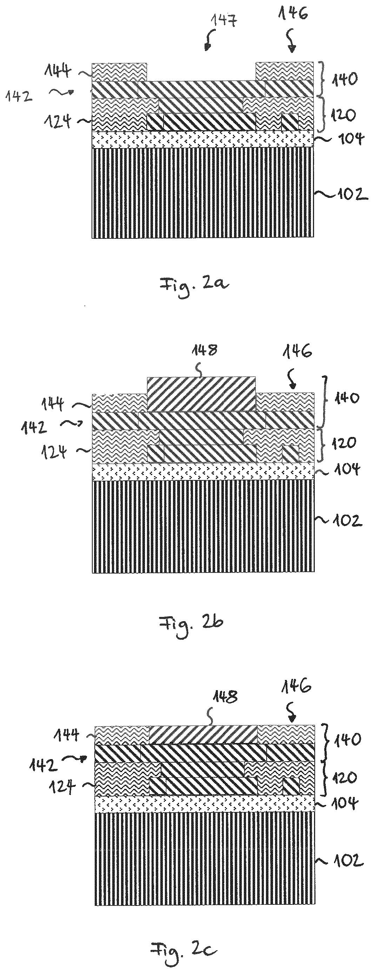

With regard to the manufacturing process for producing the semi-finished wiring product shown in FIGS. 1a and 1b, it was mentioned that the contact surfaces 148 can be introduced into the second conductive path layer 140 by means of electroplating. This process is described in more detail below using Fign. 2a-c in more detail.

Fig. 2a shows a cross-section through an intermediate product of a semi-finished wiring product in the manufacturing process before insertion of the contact surface 148. As in Fig. 1b, a section around an intersection region of one of the first conductor track arrangements 122 with one of the second conductor track arrangements 142 can be seen.

Fig. 2a shows how, in the intermediate product, the passivation layer 144 has already been applied to the second conductor track arrangements 142 and, either by omission during application of the passivation 142 or by subsequent removal of material, a recess 147 has been made in the passivation 144. The recess 147 extends from an outer surface 146 down to the second conductor track arrangement 142.

In order to insert the contact surface 148 into the recess 147 by means of electrodeposition, a voltage is applied to the conductor track arrangements 122, 142. Conductive material for producing the contact surface 148 is thereby drawn into the recess 147, which leads to growth of the contact surface 148. A fully grown contact surface 148 can be seen in Fig. 2b.

The contact surface 148 can also be produced by other methods. However, electroplating has the advantage that it does not require any additional masking or a seed layer.

Fig. 2b shows a cross-section through the intermediate production from Fig. 2a after the contact surface 148 has been inserted.

In Fig. 2b, the contact surface 148 is inserted into the recess 147 and thus the contact surface 148 is electrically conductively connected to the first conductor track arrangement 122 and the second conductor track arrangement 142 in the intersection area shown. The process for manufacturing the semi-finished wiring product 100 is thus basically complete.

In Fig. 2b (as in Fig. 1b), however, it can be seen how the contact surface 148 protrudes beyond the surface of the passivation 144 of the second conductive track layer 140. This can be helpful for some applications. For other applications, however, a contact surface 148 that is flush with the surface 146 is more advantageous. To achieve this, it is possible to partially remove the contact surface 148 mechanically by means of chemical mechanical polishing (CMP) or fly cutting. One result of this process is shown in Fig. 2c.

Fig. 2c a cross-section through the intermediate product of Fig. 2b after grinding off the contact surface 148.

The contact surface 148 now forms a plane with the surface 146. This can be advantageous, for example, if the semi-finished wiring product is to be connected to another semi-finished wiring product using hybrid bonding.

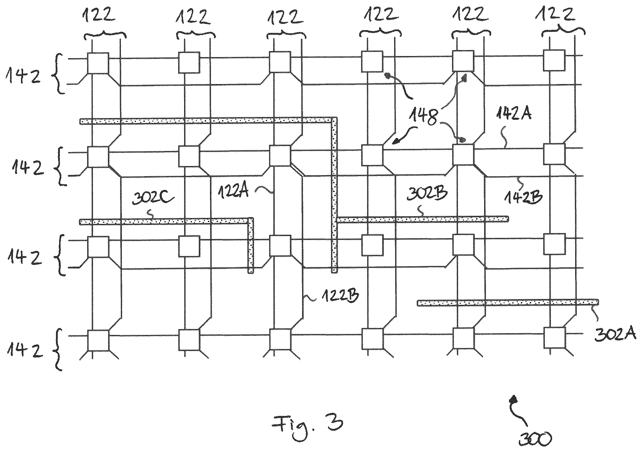

The semi-finished wiring product 100 represents a complete three-dimensional electrical network in which all contact surfaces 148 are electrically connected to one another. In order to produce a wiring module suitable for the application from the semi-finished wiring product, conductor tracks of the semi-finished wiring product 100 must be interrupted according to the specific application. This is illustrated in Fig. 3.

Fig. 3 shows a top view of a wiring module 300 made from the semi-finished wiring product 100 shown in Figs. 1a and 1b. The top view shown in Fig. 3 corresponds to the viewing direction shown in Fig. 1a.

As can be seen in Fig. 3, the wiring module 300 corresponds to the semi-finished wiring product 100. The wiring module 300 differs from the semi-finished wiring product 100 only in that an electrical conductivity of some of the first conductive paths 122A, 122B and some of the second conductive paths 142A, 142B has been selectively interrupted at different locations. This is indicated in Fig. 3 by structuring 302A-C. Structuring 302A-C interrupts the conductivity of the conductor tracks at the points where structuring 302A-C and the respective conductor track cross. As a result, the contact surfaces 148 can be connected to each other according to a predetermined three-dimensional electrical network. The three-dimensional electrical network is usually defined by a specific purpose of the wiring module.

The wiring module 300 is therefore initially manufactured by producing a semi-finished wiring product 100. The surface 146 of the semi-finished wiring material 300 is then modified by a material removal process so that the electrical conductivity of selected conductive paths is interrupted at predetermined positions. The material-removing process can be laser ablation or an etching process, for example.

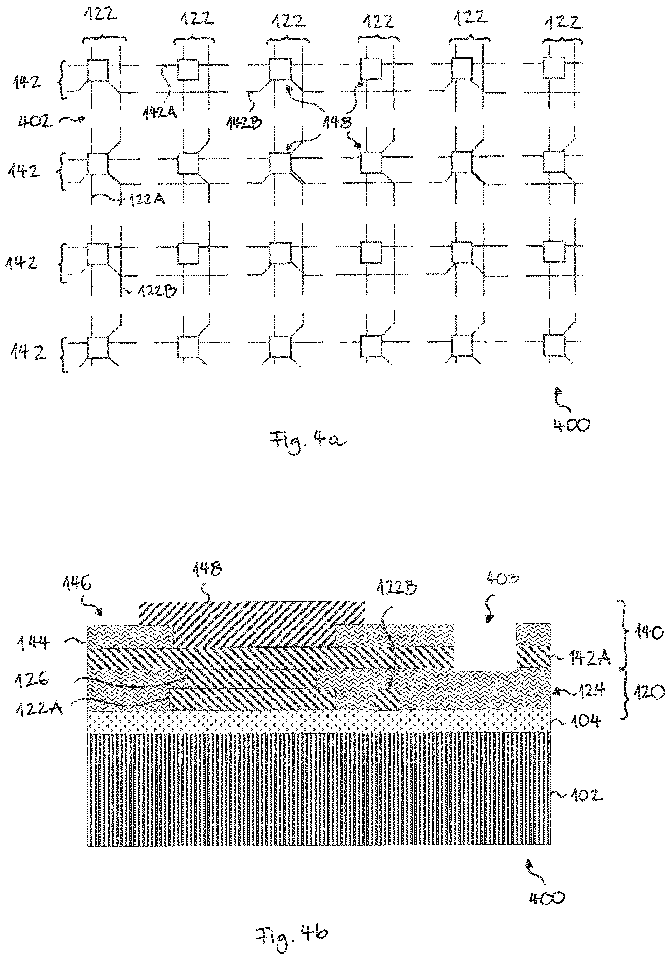

The wiring module 300 is based on the fact that conductor paths of the semi-finished wiring product 100 are interrupted according to a predetermined three-dimensional electrical network. Alternatively, it is also possible to produce a predetermined three-dimensional electrical network in which interruptions in the electrical conductivity of conductor paths are specifically produced. The semi-finished wiring product must be designed differently for such a procedure. Such another embodiment is described below with reference to Fign. 4a and 4b.

Fig. 4a shows a top view of a semi-finished wiring product 400 comprising conductive tracks which have interruptions 402 in their conductivity between adjacent contact surfaces.

The wiring module 400 shown in Fig. 4a largely corresponds to the wiring module 100 in Fig. 1a. However, the wiring module 400 differs in that the conductor tracks 122A, 122B of the first conductor track arrangement and the conductor tracks 142A, 142B of the second conductor track arrangement each have interruptions 402 in the form of narrow gaps in their course between two adjacent contact surfaces. In this example, the gaps are smaller than 5 µm. The interruptions can later be electrically bridged by adding conductive materials to create a wiring module corresponding to a predetermined three-dimensional electrical network. For this purpose, the passivation layers of the wiring module 400 have recesses, as explained below with reference to Fig. 4b.

Fig. 4b shows a cross-section through the semi-finished wiring product 400 shown in Fig. 4a. The cross-section corresponds to a cross-section along one of the first conductive tracks 142A of the second conductive track layer 140 in the region of an intersection between one of the first conductive track arrangements 122 and one of the second conductive track arrangements 142.

Laterally offset to the contact surface 148 shown in Fig. 4b, the interruption 402 of the conductivity of the conductor track 142A is visible in Fig. 4b. Above the interruption 402, there is a recess 403 in the passivation layer 144 of the second conductive track layer 140, which extends from the surface 146 of the passivation layer 144 down to the interruption 402. In the case of an interruption 402 of one of the conductive traces 122A, 122B of the first conductive trace layer 120, the recess 403 then extends analogously from the surface 146 through the passivation layer 144 of the second conductive trace layer 140 and through the passivation layer 124 of the first conductive trace layer 120 down to the interruption 402 in one of the conductive traces 122A, 122B.

The semi-finished wiring product 400 is manufactured in the same way as the semi-finished wiring product 100, with the difference that the interruptions 402 are made in the conductor tracks and the recesses 403 are made in the passivation during the manufacturing process.

The interruptions 402 can already be introduced during the application of the conductor track arrangements 122, 144 by corresponding omissions in the material application. Alternatively, it is possible to introduce the interruptions 402 in the conductor tracks by material-removing processes after the conductor tracks have been manufactured. Similarly, it is possible to introduce the recesses 403 into the passivation layers 124, 144 by means of omissions as well as subsequent material removal.

It is then possible to manufacture a wiring module from the semi-finished wiring product 400 by inserting bridging elements that bridge the interruptions 402 in the conductivity of the conductor tracks. The bridging elements can be a metallic element. Alternatively, it is also possible to use conductive polymers. These are more difficult or even impossible to detect using methods such as X-rays and can be used to conceal the layout of the electrical network realized by the wiring module and make it less accessible to reverse engineering. This is particularly interesting when implementing safety-relevant circuits.

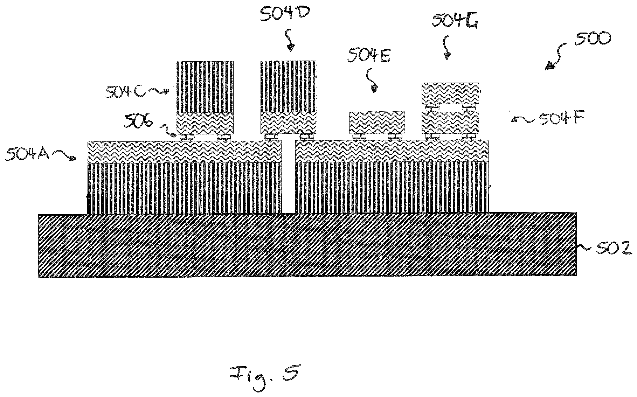

The semi-finished wiring products described above already make it possible to realize a large number of different three-dimensional electrical networks quickly and cost-effectively. However, the variety of possibilities for creating electrical networks can be further increased by combining two or more wiring modules to create an extended three-dimensional electrical network. This option is described below with reference to Fig. 5.

Fig. 5 shows a wiring component 500 comprising seven wiring modules 504A-G.

The wiring component 500 serves to illustrate the possibilities of how wiring modules can be combined with each other to form a wiring component and does not serve any specific application purpose. The options shown are examples. Other combinations are also possible.

In Fig. 5, the wiring component 500 is arranged on a printed circuit board 502. The wiring module 504A lies directly on the circuit board. If a local increase in the conductor density of the wiring module 504 is necessary, this can be made possible by attaching a second wiring module. These options are shown with the wiring module 504C. A size of the wiring module 504C can be selected so that it fulfills an application-related requirement for a local increase in the wiring density of the wiring module 500A.

Wiring module 504B and 504D further increase the wiring options. The wiring module 504B is arranged next to the wiring module 504A on the printed circuit board 502. The wiring module 504D serves as a bridge between the wiring module 504A and the wiring module 504B and is therefore arranged on both.

The wiring module 504E, which is arranged on the wiring module 504B, locally increases the line density of the wiring module 504B. It is also possible to extend the electrical network of the wiring module 504B by adding stacked wiring modules. This is exemplified by the wiring modules 504F and 504G, which are arranged one above the other on the wiring module 504B.

The manufacturing process of the wiring component 500 initially involves manufacturing a semi-finished wiring product for each of the wiring modules 504A-G. The semi-finished wiring products can, for example, be manufactured in the same way as the semi-finished wiring product 100 or the semi-finished wiring product 400. Each of the semi-finished wiring products is then processed so that the semi-finished wiring product provides the desired three-dimensional electrical network. This step turns the semi-finished wiring product into the corresponding wiring module.

Furthermore, the substrate can also be removed during the production of the wiring module. However, as can be seen in Fig. 5, this was not done in the manufacture of the wiring modules 504A-D. The substrate of the wiring modules 504A-D serves as a temporary carrier that facilitates the arrangement of the wiring modules on the printed circuit board 502. On the wiring modules 504E-G, however, the substrate has been removed to allow the wiring modules to be stacked on top of each other.

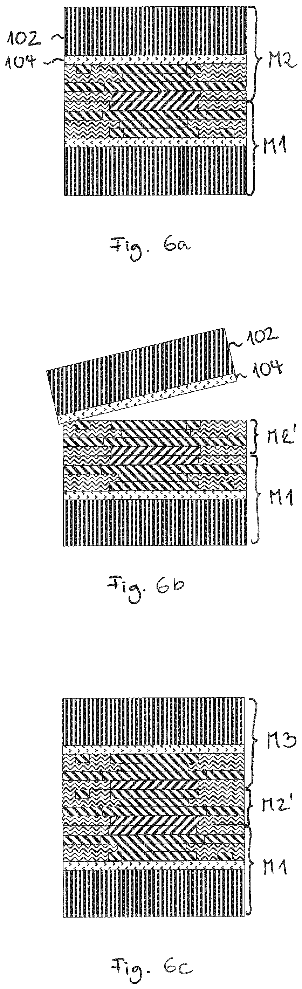

The wiring modules 504A-G were positioned on top of each other using flip-chip technology. The electrical connection between the modules was made using solder balls 506, which are applied to the contact surfaces of one of the modules and are then arranged between the contact surfaces of two modules lying on top of each other in the flip-chip method. The solder balls 506 serve as connecting elements. Alternatively, stud bumps can also be used. In addition to production using Flip-Chip-Bonding technology, it is also possible to arrange the modules on top of each other using thermo-compression technology or hybrid bonding. How hybrid bonding can be used here is explained below with reference to Fign. 6a-c.

Fig. 6a shows a first step of a manufacturing process for joining three wiring modules using hybrid bonding.

In the first step, a wiring module M2 is placed on a wiring module M1 so that the respective contact surfaces come into contact with each other. Hybrid bonding between the two wiring modules M1, M2 can then be carried out at room temperature by means of thermal post-processing (tempering) or by applying heat and pressure by means of heated bonding.

Furthermore, in hybrid bonding it is important that the surfaces of the wiring modules M1, M2 are planar in order to achieve a material bond both between the contact surfaces and between the surfaces of the passivation layer of the second conductor track layer.

Fig. 6b shows a second step of a manufacturing process for joining three wiring modules using hybrid bonding.

In the second step shown in Fig. 6a, the substrate 102 including the separating layer 104 of the upper wiring module M2 is detached. This is a prerequisite for attaching a third wiring module M3 to the second wiring module M2. However, if only two modules are to be connected to each other, this step is not absolutely necessary. In the latter case, it may be advantageous to leave the substrate 102 on the wiring module M2 for subsequent movement of the wiring component.

Once the substrate 102 and the separating layer 104 of the upper wiring module M2 have been removed, the third step of the manufacturing process can be started.

Fig. 6c shows a third step of a manufacturing process for joining three wiring modules using hybrid bonding.

In the third step of the manufacturing process, the third wiring module M3 is placed on the back of the second, now substrate-free wiring module M2' and connected using hybrid bonding. Here, contact surfaces 148 of the third wiring module are brought into correspondence with crossing points of the first conductor track arrangement with the second conductor track arrangement of the second wiring module M2'.

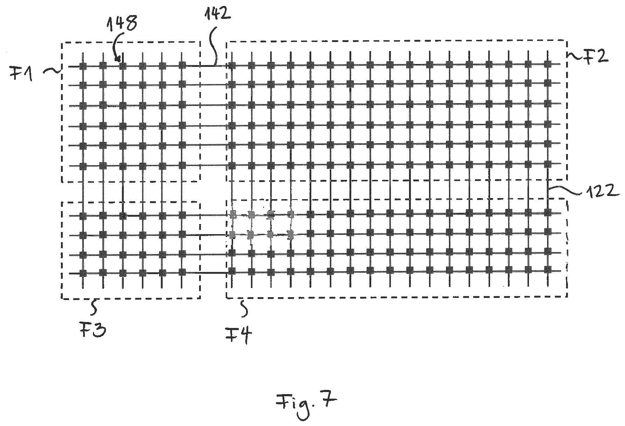

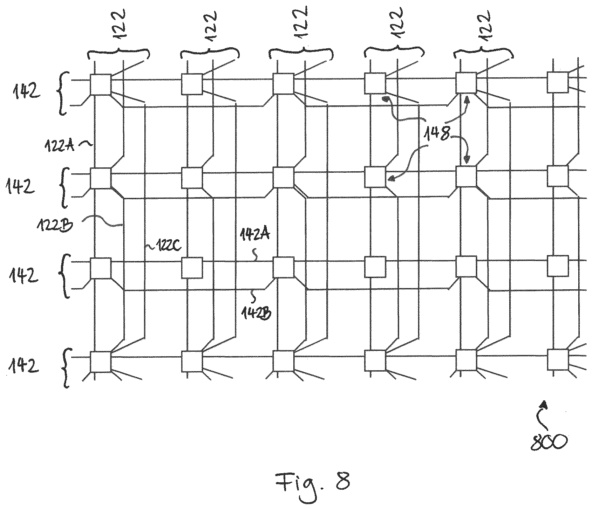

In the following, two further embodiments of a semi-finished wiring product are described with reference to FIGS. 7 and 8 are described below.

Fig. 7 shows a top view of a semi-finished wiring product 700 comprising contact surfaces 148 that are arranged periodically in four fields.

The top view shown in Fig. 7 is a simplified representation of the semi-finished wiring product 700. The first conductor track arrangements 122 and the second conductor track arrangements 142 correspond to those of the semi-finished wiring product 100 of Figs. 1a and 1b. To simplify matters, however, they are only shown as a single line in Fig. 7 and do not show the individual conductor tracks.

In the semi-finished wiring product 700 shown in Fig. 7, the contact surfaces 148 are arranged periodically in four separate fields F1-F4. This is achieved by using wider spacings between individual conductor track arrangements than for the other conductor track arrangements. The resulting fields F1-F4 are spaced apart, but are still conductively connected to each other due to the continuous conductor track arrangements. This type of arrangement makes it possible to divide the semi-finished wiring product 700 into small units, for example by means of dicing, and to use these individually. Alternatively, the entire semi-finished wiring product 700 can also be used as a single unit. The layout shown here is just one example. Other divisions are possible.

Fig. 8 shows a top view of a semi-finished wiring product 800 with a first conductor track arrangement comprising three conductor tracks.

The semi-finished wiring product 800 shown in Fig. 8 corresponds to the semi-finished wiring product 100 in Figs. 1a and 1b. The only difference between the semi-finished wiring product 100 and the semi-finished wiring product 800 is that the conductor track arrangements 122 comprise a third conductor track 122C. The third conductor 122C is only connected to every third contact surface along its path. This enables even more complex wiring. In addition, a third conductor track can also be used in the second conductor track arrangement 142. It is also not absolutely necessary for the third conductor 122C to make contact with every third contact surface. The third conductor 122C can also connect any other number of contact surfaces.

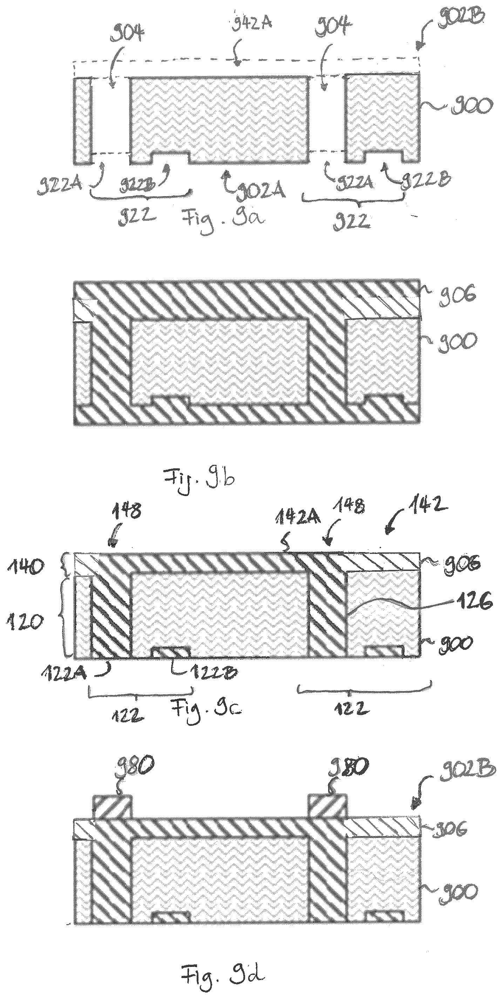

Finally, with reference to Figs. 9a-d, an alternative method for manufacturing the semi-finished wiring product shown in Figs. 1a,b is described below.

Figs. 9a-d show illustrations of process steps of an alternative method for manufacturing a semi-finished wiring product using a pre-machined substrate.

The process described above for manufacturing the semi-finished wiring product shown in Fig. 1a,bis based on the layer-by-layer application of material. However, it is also possible to manufacture the semi-finished wiring product using a pre-processed substrate, in this case a glass substrate. The first step in this process is therefore to provide such a pre-processed glass substrate.

Fig. 9a shows a cross-section of a pre-processed glass substrate 900.

The pre-processed glass substrate 900 is a continuous, cuboid glass block comprising a number of channels formed in the glass substrate 900. Thus, the glass substrate 900 comprises first channel arrangements 922 extending perpendicularly to the cross-sectional plane on a first side 902A shown as the underside in Figs. 9a-d. Each of the channel arrangements 922 comprises two parallel channels 922A and 922B, which will later form the conductor pairs of the first conductor arrangement of the first conductor track layer.

On a second side 902B of the pre-processed glass substrate 900, shown as the upper side in Fig. 9a, second channel arrangements 942 are arranged, which run parallel to the plane of the cross-section. The second channel arrangements 942 also each comprise a first channel and a second channel running parallel to the first channel, whereby only the first channel 942A is indicated by dashed lines in Fig. 9a due to the course of the channels parallel to the plane of the cross-section.

The cross-section shown in Fig. 9a runs through two intersection regions in which the channels of the top layer 902B and bottom layer 902A cross and which later form intersection regions of first and second conductor track arrangements. In order to be able to establish a conductive connection between the first and second conductor track arrangements intersecting within an intersection region, a vertically extending through-hole 904 is arranged in the pre-machined glass substrate 900 in each of the intersection regions.

The pre-processed glass substrate 902 can be produced by means of laser-induced etching, for example. However, other manufacturing processes for inserting the channels and through-holes into the glass substrate are also possible.

After the pre-processed glass substrate 900 has been prepared, it is metallized to apply the conductive tracks. This is described below with reference to Fig. 9b.

Fig. 9b shows the pre-processed glass substrate 900 from Fig. 9a after application of a metal layer 906.

Metallization fills the channels running along the top side 902A and the bottom side 902B as well as the through holes 904 with metal. Metallization can be carried out by applying a seed layer and subsequent electroplating. Copper can also be used as a material here. The seed layer can be applied by sputtering. Electroless deposition of the seed layer on the surfaces of the glass substrate 900 is also possible. Alternatively, metallization can be achieved by inserting a copper paste into the channels and through-holes and then sintering.

As shown in Fig. 9b, metallization on the upper surface 902B and on the lower surface 902A often results in too much metal being applied, so that a conductive connection is created via the surface, even between the channels of a surface. For this reason, it is often useful to grind off the metallization after application to the surfaces 902A, 902B until the glass substrate is exposed between the channels. This process is described below with reference to Fig. 9c.

Fig. 9c shows the pre-machined glass substrate 902 with the metal layer 906 after grinding off the metal layer 906.

As can be seen in Fig. 9c, particularly in the region of the underside 902A of the pre-processed glass substrate 900, the metal layer 906 is abraded to such an extent that there is no metallic conductive connection via the surface 902A either between the first channel arrangements 922 or between the channels 922A and 922B of one of the first channel arrangements.

The glass substrate 900 with the metallization 906 as shown in Fig. 9c already corresponds to the finished semi-finished wiring product. The first channel arrangements 922 on the underside 902A, which are filled by the metallization, form the first conductor track arrangements 122, each of which has a first conductor track 122A and a second conductor track 122B. The second channel arrangements filled by the metallization on the upper side 902B form the second conductor track arrangements 142, of which only a first conductor track 142A can be seen in Fig. 9c. The first conductor track layer 120 corresponds to the area from the underside 902A to the underside of the conductor track 142A. Furthermore, the second conductor track area 140 corresponds to the area between the underside of the conductor track 142A to the top side of the conductor track 142A. The electrical connection between the first conductor track arrangement 122 and the second conductor track arrangement 142 in the intersection regions is realized by contact elements 126 inserted into the through-holes 904 by means of the metallization step. outer surfaces of the conductor tracks of the second conductor track arrangement in the intersection region can serve as contact surfaces 148.

In a final step, a solderable metallization can also be applied to the intersection regions between the conductor track arrangements on the top side 902B or on the bottom side 902A by means of a seed layer and electroplating. The semi-finished wiring product after carrying out this process step is shown in Fig. 9d. Solderable metallizations 980 are arranged on the upper side 902B.

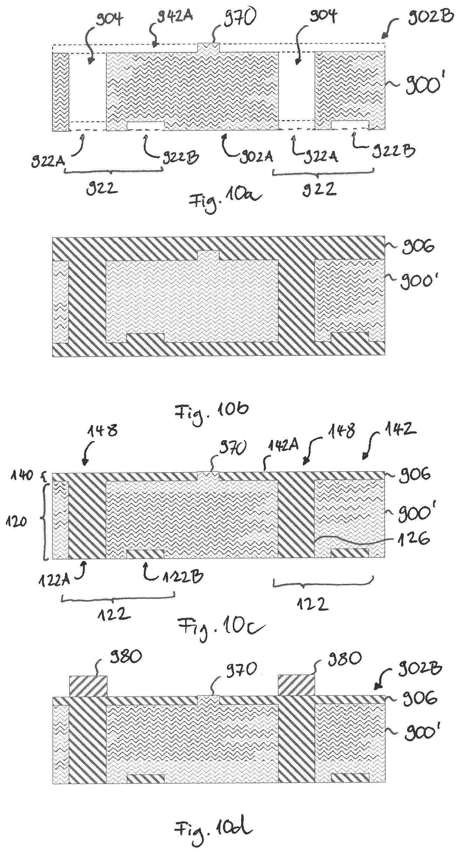

In the process shown in Figs. 9a-d, a semi-finished wiring product is produced in which the conductive paths 122A,B and 142A,B are continuously conductive along their course. The semi-finished wiring product is customized by selectively interrupting individual conductor paths. Alternatively, it is also possible to manufacture the semi-finished wiring product with interrupted conductor paths, so that the semi-finished wiring product can be customized by inserting electrically conductive bridges. A manufacturing process for producing a semi-finished wiring product with interrupted conductor tracks is shown in Fign. 10a-d is shown.

Fign. 10a-d show illustrations of process steps of a method for manufacturing a semi-finished wiring product using a pre-machined glass substrate with interruptions.

The process shown in Fign. 10a-d is identical to the method shown in Figs. 9a-d. The only difference is that a pre-processed glass substrate 900' is used. This pre-processed glass substrate 900' comprises interruptions 970 in the channels (see 924A in Fig. 10a) of the channel arrangement 922, 942 along their respective course between two adjacent intersection regions. As can be seen in Fig. 10c, these interruptions 970 lead to interruptions in the electrical conductivity of the conductor tracks after the metallization has been applied.

In summary, the present disclosure describes a semi-finished wiring product (100) comprising a first conductive track layer (120) and a second conductive track layer (140). The first conductor track layer (120) has a plurality of first conductor track arrangements (122) extending parallel to one another. The second conductor track layer (140) is arranged on a surface of the first conductor track layer (120) and has a plurality of second conductor track arrangements (142) extending parallel to one another. The arrangement is such that at least one of the second conductor track arrangements (142) intersects one of the first conductor track arrangements (122). Furthermore, an outer surface (146) of the second conductive track layer (120) has a contact surface (148) in at least one intersection region, at which one of the first conductive track arrangements (122) intersects with one of the second conductive track arrangements (142), which is electrically conductively connected to the first and second conductive track arrangements (122, 142) located in the intersection region. The first conductive track arrangements (122) and the second conductive track arrangements (142) further comprise a first conductive track (122A, 142A) electrically connected to each contact surface (148) arranged along its course. Furthermore, the first conductor track arrangements (122) and/or the second conductor track arrangements (148) each comprise a second conductor track (122B, 142B) which is electrically connected to at most every second contact surface (148) arranged along its course.

## Claims

1. A semi-finished wiring product (100) comprising:
a first conductor track layer (120) comprising a plurality of first conductor track arrangements (122) extending parallel to each other;
a second conductor track layer (140) arranged on a surface of the first conductor track layer and having a plurality of second conductor track arrangements (142) extending parallel to one another, wherein
at least one of the second conductor track arrangements (142) intersects one of the first conductor track arrangements (122), and
an outer surface (146) of the second conductor track layer (120) has, in at least one intersection region where one of the first conductor track arrangements (122) intersects with one of the second conductor track arrangements (142), a contact surface (148) which is connected electrically to the first and second conductor track arrangements (122, 142) located in the intersection region; wherein
the first conductor track arrangements (122) and the second conductor track arrangements (142) each comprise a first conductor track (122A, 142A) electrically connected to each contact surface (148) arranged along its course; and
the first conductor track arrangements (122) and/or the second conductor track arrangements (148) each comprise a second conductor track (122B, 142B) which is electrically connected to at most every second contact surface (148) arranged along its course.

2. The semi-finished wiring product (100) according to claim 1, wherein
the first conductor track arrangements (122) and/or the second conductor track arrangements (142) are spaced apart such that a periodic arrangement of the contact surfaces (148) results or that a plurality of spaced-apart fields (F1-F4) results in which the contact surfaces (148) are periodically arranged.

3. The semi-finished wiring product (400) according to claim 1 or 2, wherein
one or more conductor tracks (122A,B, 142A,B), preferably all conductor tracks, of the first and/or the second conductor track arrangement (122, 148) have an interruption (402) in the electrical conductivity along their course between two adjacent contact surfaces (148).

4. The semi-finished wiring product (400) according to claim 3, wherein the outer surface (146) of the second conductor track layer (140) comprises above each of one or more of the interruptions (402) a recess (403), which vertically extends to the interruption (402).

5. The semi-finished wiring product (800) according to one of the preceding claims, wherein the first conductor track arrangements (122) and/or the second conductor track arrangements (142) comprise a third conductor track (122C) which runs parallel to the first and second conductor tracks (122A, B) and is electrically connected along its course to at most every third contact surface (148).

6. The semi-finished wiring product (100) according to one of the preceding claims, wherein
the first conductor track layer (120) comprises a passivation layer (124) which electrically insulates the first conductor track arrangements (122) and the second conductor track arrangements (142) from one another, wherein an electrically conductive contact element (126) is arranged in each of the intersection regions within the passivation layer (124), which electrically connects the first conductor track arrangement (122) located in the intersection region to the second conductor track arrangement (142), and/or
the second conductor track layer (140) comprises a passivation layer (144) which covers the second conductor track arrangements (142) and forms the outer surface (146), wherein the passivation layer (144) comprises recesses (147) in the intersection regions in which the contact surfaces (148) are arranged.

7. A method of manufacturing a semi-finished wiring product, comprising the following steps:
Providing a pre-processed substrate (900), comprising:
a first surface (902A) and a second surface (902B) opposite the first surface,
first channel arrangements (922) in the form of parallel recesses in the first surface (902A),
second channel arrangements (942) in the form of parallel recesses in the second surface (902B), wherein at least one of the first channel arrangements (922) intersects one of the second channel arrangements (942),
in at least one intersection region where one of the first channel arrangements (922) intersects with one of the second channel arrangements (942), a through hole (904) extending perpendicular to the surfaces and connecting the first channel arrangement (922) with the second channel arrangement (942), wherein
the first channel arrangements (922) and the second channel arrangements (942) each comprise a first channel (922A) connected to each through hole (904) disposed along its course; and
the first channel arrangements (922) and/or the second channel arrangements (942) each comprise a second channel (922B) which is connected to at most every second through hole (906) arranged along its course;
Introducing a metallization (906) into the at least one through hole (906) and the channel arrangements (922, 942) of the pre-processed substrate for producing a first conductor track arrangement (122) in the first channel arrangement (922), a second conductor track arrangement (142) in the second channel arrangement (942) and, in at least one intersection region, a contact surface (148) which is electrically connected to the first and second conductor track arrangements (122, 142) located in the intersection region.

8. The method according to the preceding claim, wherein one or more channels, preferably all channels, of the first and/or the second channel arrangement (922, 942) of the pre-processed substrate have an interruption along their respective course between two adjacent intersection regions.

9. A method of manufacturing a semi-finished wiring product (100), in which:
a first conductor track layer (120) having a plurality of first conductor track arrangements (122) extending parallel to each other is applied to a surface of a substrate (102);
a second conductor track layer (140) is applied to a surface of the first conductor track layer (120) facing away from the substrate (102), wherein the second conductor track layer (140) has a plurality of second conductor track arrangements (142) extending parallel to one another, wherein
the second conductor track arrangements (142) are applied such that at least one of the second conductor track arrangements (142) intersects at least one of the first conductor track arrangements (122), and
a contact surface (148) is applied to an outer surface (146) of the second conductor track layer (120) in at least one intersection region where one of the first conductor track arrangements (122) intersects with one of the second conductor track arrangements (142), which contact surface is electrically conductively connected to the first and second conductor track arrangements (122, 142) located in the intersection region; wherein
the first conductor track arrangements (122) and the second conductor track arrangements (142) each comprise a first conductor track (122A, 142A) which is electrically connected to each contact surface (148) arranged along its course, and
the first conductor track arrangements (122) and/or the second conductor track arrangements (142) each comprise a second conductor track (122B, 142B) which is electrically connected to at most every second contact surface (148) arranged along its course.

10. The method according to the preceding claim, wherein
the first conductor track layer (120) and/or the second conductor track layer (140) are applied by means of thin-film technology, and/or
a release layer (104) is applied to the surface of the substrate (102) before the first conductor track layer (120) is applied.

11. The method according to claim 9 or 10, wherein
when applying the first conductor track layer (120), the first conductor track arrangements (122) are first applied and then the first conductor track arrangements (122) are covered with a passivation layer (124), wherein
in regions which forms a intersection region after application of the second conductor track layer (140), a recess is introduced each which extends from a surface of the passivation layer (124) facing away from the substrate (102) to the respective first conductor track arrangement (122).

12. The method according to any one of claims 9 to 11, wherein
when applying the second conductor track layer (140), first the second conductor track arrangements (142) are applied and then the second conductor track arrangements (142) are covered with a passivation layer (144), wherein
a recess (147) is formed in each of the intersection regions, wherein the recess extends from a surface of the passivation layer (124) facing away from the substrate (102) to the second conductor track arrangement (142), and
the contact surfaces (148) are introduced into the recesses (147) of the passivation layer (144), preferably by electroplating.

13. The method according to any one of claims 9 to 12, wherein
one or more conductor tracks (122A,B, 142A,B), preferably all conductor tracks, of the first and/or the second conductor track arrangement (122, 142) are applied in such a way that a conductivity of the one or more conductor tracks (122A,B, 142A,B) is interrupted along their course between two adjacent contact surfaces (148), and
a recess (403) is made in the outer surface (146) of the second conductor track layer (140) above one or more of the interruptions (402), with the recess extending vertically to the interruption (402).

14. A wiring module (300) comprising:
a first conductor track layer (120) comprising a plurality of first conductor track arrangements (122) extending parallel to each other;
a second conductor track layer (140) disposed on a surface of the first conductor track layer (120) and comprising a plurality of second conductor track arrangements (142) extending parallel to each other, wherein
at least one of the second conductor track arrangements (142) intersects one of the first conductor track arrangements (122),
an outer surface (146) of the second conductive track layer (140) has, in at least one intersection region where one of the first conductive track arrangements (122) intersects with one of the second conductive track arrangements (142), a contact surface (148) which is electrically connected to the first and second conductive track arrangements (122, 142) located in the intersection region; wherein
the first conductor track arrangements (122) and the second conductor track arrangements (142) each comprise a first conductor track (122A, 142A) which is electrically connected to each contact surface (148) arranged along its course;
the first conductor track arrangements (122) and/or the second conductor track arrangements (148) each comprise a second conductor track (122B, 142B) which is electrically connected to at most every second contact surface (148) arranged along its course; and
a conductivity of the first conductor track arrangements (122) and/or a conductivity of the second conductor track arrangements (142) is structured so that the contact surfaces (148) are electrically connected to one another in accordance with a predetermined three-dimensional electrical network.

15. A method of manufacturing a wiring module (300), comprising the following steps:
Performing the method steps according to any one of claims 7 and 9 to 12;
between adjacent contact surfaces (148), structuring the electrical conductivity of the first conductor track arrangements (122) and/or the second conductor track arrangements (142) by means of a material removal process in accordance with a predetermined three-dimensional electrical network, and/or
Carrying out the method steps according to claim 8 or 13, and
Insertion of bridging elements for establishing an electrical conductivity bridging any of the one or more interruptions (402) according to the predetermined three-dimensional electrical network.

16. A wiring component (500) comprising at least a first wiring module (504A) and a second wiring module (504B) according to claim 14, wherein
the first wiring module (504A) and the second wiring module (504B) are materially bonded together to form a predetermined extended three-dimensional electrical network, wherein
Contact surfaces (148) of the first wiring module (504A) are connected pairwise to contact surfaces (148) of the second wiring module (504B) directly or via a connecting element (506) located between the outer surfaces of the wiring modules.

17. A method of manufacturing a wiring component (500), comprising the steps of:
Manufacturing a first wiring module (504A) by means of the method steps according to claim 15;
Manufacturing a second wiring module (504B) by means of the method steps according to claim 15;
material bonding of the first wiring module (504A) and the second wiring module (504B), preferably by means of flip-chip bonding and/or hybrid bonding, to form a predetermined extended three-dimensional electrical network, wherein
Contact surfaces (148) of the second wiring module (504A) are connected pairwise to contact surfaces (148) of the first wiring module (504B) directly or via a connecting element (506) located between the outer surfaces (147) of the wiring modules (504A, B).
